# EUROPEAN PATENT SPECIFICATION

(11) **EP 4 034 963 B1**
(45) Date of publication and mention of the grant of the patent: **27.11.2024**
(21) Application number: 19786282.4
(22) Date of filing: 30.09.2019
(51) Int. Cl.: G06F 1/02, G06F 1/03, H03D 3/00, H03D 7/14

(54) **DDFS FOR A MIXER OF A DOWNCONVERTER**
DDFS FÜR EINEN MISCHER EINES ABWÄRTSWANDLERS
DDFS POUR UN MÉLANGEUR D'UN CONVERTISSEUR-ABAISSEUR

(43) Date of publication of application: 03.08.2022
(73) Proprietor: Huawei Technologies Co., Ltd., Longgang District Shenzhen, Guangdong 518129 (CN)
(72) Inventor: RIEKKI, Jonne, 16440 Kista (SE)
(74) Representative: Thun, Clemens
(86) International application number: PCT/EP2019/076448
(87) International publication number: WO 2021/063478

(56) References cited:
- US-A1- 2008 123 777
- US-A1- 2011 275 341
- FENG S ET AL: "RF Front-End of Direct Conversion Receiver RFIC for CDMA-2000", IEEE JOURNAL OF SOLID-STATE CIRCUITS, IEEE, USA, vol. 39, no. 10, 1 October 2004 (2004-10-01), pages 1622 - 1632, XP011119165, ISSN: 0018-9200, DOI: 10.1109/JSSC.2004.833551

## Description

### Technical Field

The invention relates to a DDFS for a mixer of a downconverter. Furthermore, the invention also relates to a mixer, a downconverter and a corresponding method.

### Background

In wireless frequency division duplex (FDD) systems the received and transmitted radio frequency (RF) signals are located at different radio frequencies. The received RF signal is downconverted around DC frequency, i.e. zero frequency, with a local oscillator (LO) signal into a baseband signal at the receiver. At the downconverter output the downconverted transmitted signal is at a duplex distance, i.e. the distance between the received signal and transmitted signal, while the downconverter im2 product. i.e. the second order nonlinearity, is centered around zero frequency. The second order nonlinearity is mostly due to mismatch between switches in the mixer of analogue and digital downconverters. The second order nonlinearity limits the signal-to-noise and distortion ratio (SNDR) of the received signal.

In conventional downconverters the second-order input intercept point (IIP2) calibration is performed by tuning the DC bias voltage of the LO signals independently for each of the switches of the mixer. By tuning the DC level of the LO signals, the mismatch between the switches of the mixer can be compensated. In order to tune the DC level of the LO signals, DC decoupling between mixer gate terminals and LO signals is required.

In a conventional analog mixer of a downconverter the gate terminals of the switches are decoupled from the LO signals with the use of capacitors and the DC bias voltages are connected to the gate terminals of the switches via large resistors. The DC bias voltages can be used for compensating the mismatch of the switches of the mixer. For example, if the threshold voltage is 20mV higher on a switch a first DC bias voltage can be tuned 20mV higher than a second DC bias voltage to compensate the threshold voltage mismatch. The threshold voltage is the voltage between the gate and the source terminal of the switch. Typically, the DC voltage of the source terminal (and drain terminal) is set by the analog baseband filter at the output of the mixer which is typically half the supply voltage, i.e. VDD/2, for all mixer outputs.

Further, US 2008/123777 A1 refers to a receiver including a direct digital frequency synthesizer (DDFS) and first and second mixers. The DDFS has a first output for providing a first local oscillator signal, and a second output for providing a second local oscillator signal offset from a quadrature relationship with the first local oscillator signal by a phase offset. The first mixer has a first input for receiving a radio frequency (RF) signal, a second input for receiving the first local oscillator signal, and an output for providing an in-phase signal at another frequency. The second mixer has a first input for receiving the RF signal, a second input for receiving the second local oscillator signal, and an output for providing a quadrature signal at the other frequency. The DDFS may be implemented using first and second memories storing portions of a sinusoidal waveform and extra memories supporting the phase offset.

Further, the document Feng. S. et.al., IEEE Journal of Solid-State Circuits, IEEE, USA, vol. 39, no. 10, October 1, 2004, pages 1622-1632, refers to a RF Front-End of Direct Conversion Receiver RFIC for CDMA-2000.

Further, US 2011/275341 A1 refers to a radio frequency receiver on an integrated circuit (RFIC) including an oscillator circuit, which generates a radio frequency (RF) oscillatory signal having a predetermined frequency that is outside of an intermediate frequency passband of the RFIC. An amplitude modulator modulates the RF oscillatory signal to produce an amplitude modulated signal, which is applied to a mixer that downconverts the amplitude modulated signal. A calibration circuit receives the downconverted signal, including second order modulation (IM2) products, and, responsive to the IM2 products, generates a bias signal that is applied to the mixer to reduce the IM2 products.

### Summary

An objective of embodiments of the invention is to provide a solution which mitigates or solves the drawbacks and problems of conventional solutions.

The above and further objectives are solved by the subject matter of the independent claims. Further advantageous embodiments of the invention can be found in the dependent claims.

According to a first aspect of the invention, the above mentioned and other objectives are achieved with a digital frequency synthesis circuit according to claim 1.

An advantage of the digital frequency synthesis circuit according to the first aspect is that all desired LO frequencies can be generated from a single clock frequency (CLK). Also, the LO signal waveform can be freely chosen. Moreover, the calibration can be done on the digital side. Hence, no additional components such as decoupling capacitors and resistors are needed on the analog side in the mixer of the downconverter. This implies more compact layout (smaller chip size) in the mixer and cost saving when producing the mixer. Further, better matching between cells of the mixer is achieved which results in improved SNDR and lower current consumption due to lower parasitic effects in the mixer.

In an implementation form of a digital frequency synthesis circuit according to the first aspect, the converter block further is configured to
reduce the amplitude of the LO signal from digital full-scale.

An advantage with this implementation form is that the LO signal waveform is maintained after adding the calibration code. If the LO signal waveform clips the harmonic content of the LO is changed thus degrading the harmonic rejection of the mixer.

In an implementation form of a digital frequency synthesis circuit according to the first aspect, the converter block further is configured to
convert the phase slope signal to the LO signal using a square wave signal or a sine wave signal.

An advantage with this implementation form is that by using a square wave signal higher conversion gain is possible which means that the signal at the mixer output is higher. By using a sine wave signal the LO signal does not mix from its harmonics since the sinewave does not have harmonics.

In an implementation form of a digital frequency synthesis circuit according to the first aspect, the adder block further is configured to
add a calibration code value to the LO signal so that a maximum value of the LO signal including the calibration code value is less than digital full-scale.

An advantage with this implementation form is that the LO signal waveform is maintained after adding the calibration code.

In an implementation form of a digital frequency synthesis circuit according to the first aspect, the adder block further is configured to
add a calibration code value to the LO signal so that a minimum value of the LO signal including the calibration code value is greater than zero.

An advantage with this implementation form is that the LO signal waveform is maintained after adding the calibration code.

In an implementation form of a digital frequency synthesis circuit according to the first aspect, the calibration code value is a constant value.

An advantage with this implementation form is that the calibration can be done at factory and correct calibration values for the mixer application can be selected from predefined tables. This means that the mixer is already calibrated at delivery since no calibration is needed at start-up of the mixer/downconverter.

In an implementation form of a digital frequency synthesis circuit according to the first aspect, the constant value is predefined and tuned for a mixer of the downconverter.

An advantage with this implementation form is that no calibration is needed at start-up of the mixer/downconverter.

In an implementation form of a digital frequency synthesis circuit according to the first aspect, the calibration code value is tuned for removing second order nonlinearities of the mixer.

An advantage with this implementation form is that the second order nonlinearities of the mixer are removed or mitigated.

An advantage of the mixer according to the second aspect is that the calibration can be done on the digital side.

In an implementation form of a mixer according to the second aspect, the mixer further lacking decoupling capacitors and bias resistors. This implies more compact layout (smaller chip size) in the mixer and cost saving when producing the mixer. Further, better matching between cells of the mixer is achieved which results in improved SNDR and lower current consumption due to lower parasitic effects in the mixer.

According to a third aspect (an embodiment) of the invention, the above mentioned and other objectives are achieved with a downconverter for downconverting a radio frequency signal to a baseband signal, the downconverter comprising
a digital frequency synthesis circuit according to any implementation form of a digital frequency synthesis circuit according to the first aspect, and
a mixer according to any implementation form of a digital mixer according to the second aspect.

According to a fourth aspect of the invention, the above mentioned and other objectives are achieved with a method according to claim 12.

The method according to the fourth aspect can be extended into implementation forms corresponding to the implementation forms of the digital frequency synthesis circuit according to the first aspect. Hence, an implementation form of the method comprises the feature(s) of the corresponding implementation form of the digital frequency synthesis circuit.

The advantages of the methods according to the fourth aspect are the same as those for the corresponding implementation forms of the digital frequency synthesis circuit according to the first aspect.

Further applications and advantages of the embodiments of the invention will be apparent from the following detailed description.

### Brief Description of the Drawings

The appended drawings are intended to clarify and explain different embodiments of the invention, in which:
- Fig. 1 shows a DDFS according to an embodiment of the invention;
- Fig. 2 shows a flow chart of a method according to an embodiment of the invention;
- Fig. 3 shows a DDFS and a mixer according to an embodiment of the invention;
- Fig. 4a-4c shows signalling diagrams illustrating embodiments of the invention;
- Fig. 5a and 5b illustrates back off from full scale;
- Fig. 6 shows a downconverter according to an embodiment of the invention;
- Fig. 7 illustrates calibration test signals and second order intermodulation at the receiver output;
- Fig. 8 and 9 show performance results; and
- Fig. 10 illustrates a wireless communication system.

### Detailed Description

As aforementioned the IIP2 calibration of conventional digital downconverters is performed by changing the DC bias voltages of the calibration voltages for the I-path and Q-path, respectively. However, according to the invention the IIP2 calibration is performed in the digital side contrary to conventional solutions. By changing the DC bias voltage of the digital LO signal, any mismatch of the switches of the mixer can be compensated hence moving the IIP2 calibration functionality from the analog side to the digital side. Furthermore, according to aspects of the invention instead of generating full-scale LO signal in the Direct Digital Frequency Synthesis (DDFS), the LO signal amplitude is lowered, i.e. backed-off from digital full-scale, so as to leaving room for DC level adjustments. The offset value, i.e. the IIP2 calibration value, can then be added in the DDFS to the digital LO signal to compensate the switching mismatch in the mixer of the downconverter.

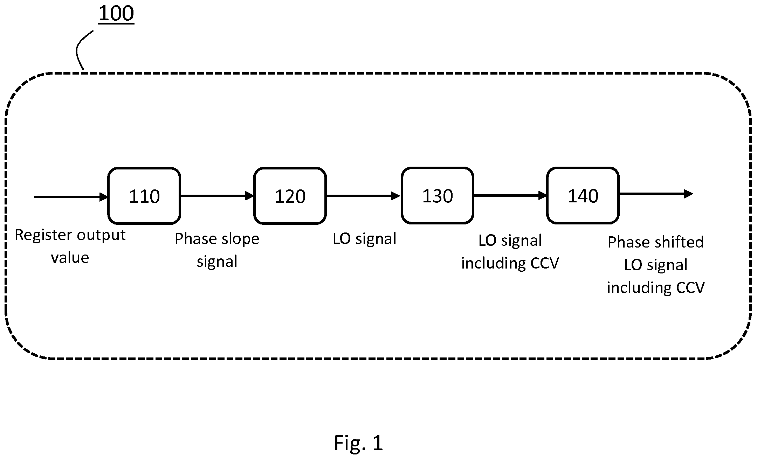

Fig. 1 shows a block diagram of a DDFS 100 according to an embodiment of the invention. The DDFS 100 includes both an I-path and a Q-path, and further comprises a phase accumulator block 110 configured to obtain a register output value and generate a phase slope signal by adding a frequency control word (FCW) to the register output value. The DDFS further comprises a converter block 120 configured to convert the phase slope signal to a LO signal and an adder block 130 configured to add a calibration code value (CCV) IIP2CAL_I, IIP2CAL_Q to the LO signal. The DDFS 100 further comprises a differential block 140 configured to generate a phase shifted LO signal including the calibration code value IIP2CAL_I, IIP2CAL_Q by phase shifting the LO signal including the calibration code value IIP2CAL_I, IIP2CAL_Q.

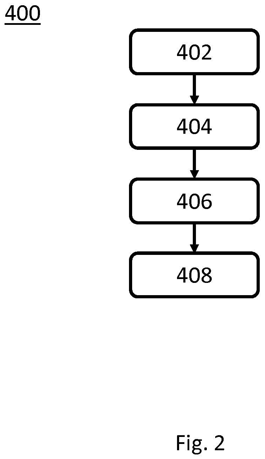

Fig. 2 shows a flow chart of a corresponding method 400 for generating a LO signal for a digital frequency synthesis circuit 100, such as the one shown in Fig. 1. The method 400 comprises obtaining 402 a register output value and generating 404 a phase slope signal by adding a FCW to the register output value. The method 400 further comprises converting 406 the phase slope signal to a LO signal and adding 408 a calibration code value IIP2CAL_I, IIP2CAL_Q to the LO signal. The method 400 further comprises generating 410 a phase shifted LO signal including the calibration code value IIP2CAL_I, IIP2CAL_Q by phase shifting the LO signal including the calibration code value IIP2CAL_I, IIP2CAL_Q.

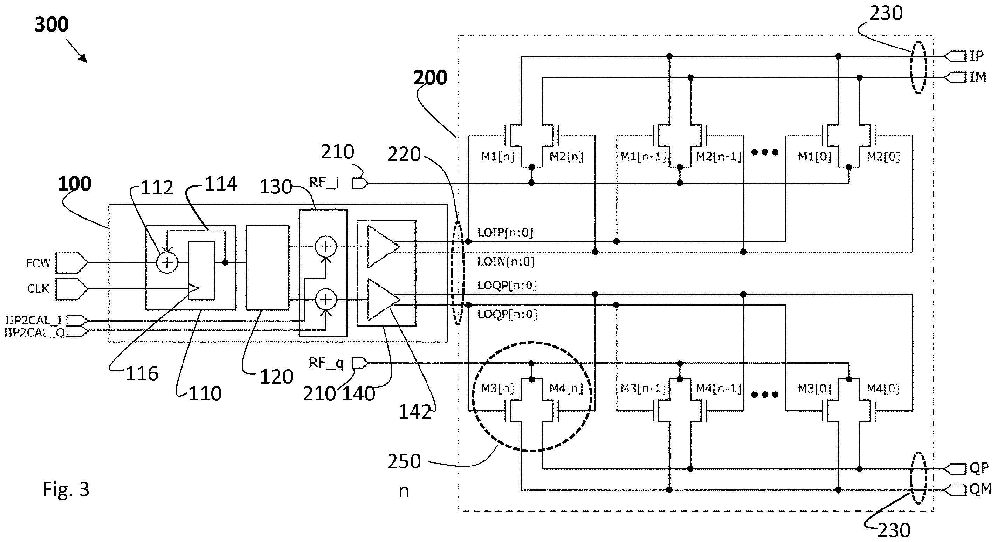

Fig. 3 shows a digital downconverter 300 comprising a DDFS 100 according to an embodiment of the invention. The general function of the downconverter 300 and its mixer 200 is to convert a high frequency RF input signal, e.g. around 2 GHz to zero frequency, to obtain a baseband signal representation of the RF signal. The mixer 200 therefore multiplies the 2 GHz input signal with the 2 GHz LO signal which results in a zero-frequency output signal.

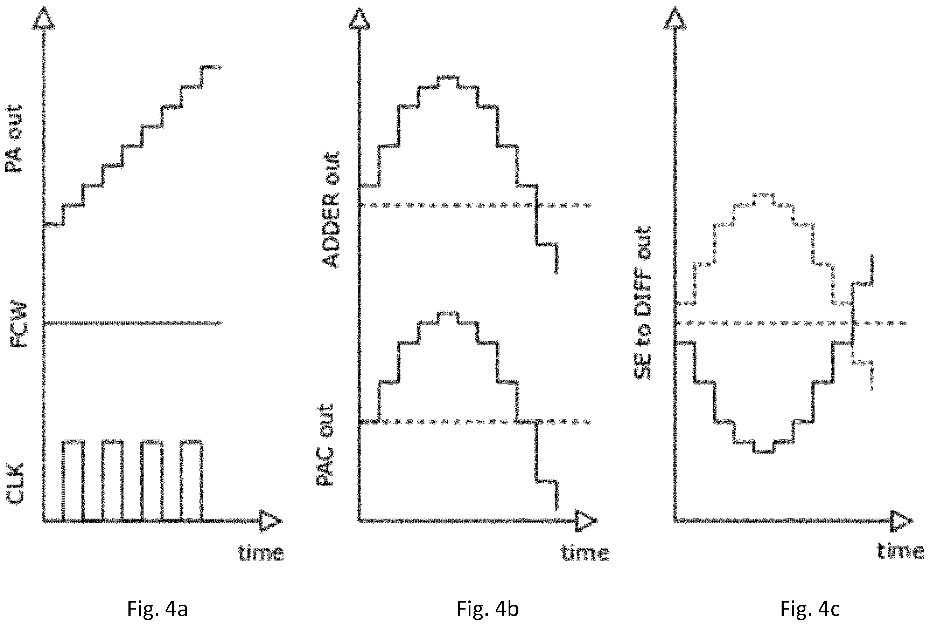

The DDFS 100 comprises as aforementioned a phase accumulator block 110, a phase-to-amplitude converter block 120, an adder block 130, and a single-ended-to-differential block 140 which are described more in detail in the following disclosure. The corresponding signal waveforms at the DDFS 100 for different processing steps are illustrated in Figs. 4a-4c.

Furthermore, the DDFS 100 in Fig. 3 is connected to a mixer 200 of a downconverter 300. Hence, the differential block 140 is configured to provide the phase shifted LO signal including the calibration code value IIP2CAL_I, IIP2CAL_Q to the mixer 200. In embodiments, the mixer 200 includes an I-path and a Q-path. The mixer 200 also comprises a first input(s) 210 configured to receive a radio frequency signal RF_i, RF_q for downconversion, and to provide the RF signal RF_i, RF_q, respectively, to a plurality of switches M1[0] - M4[0]. The mixer 200 further comprises a second input(s) 220 configured to receive a phase shifted LO signal including a calibration code value, i.e. LOIP, LOIN, LOQP, LOON from the DDFS 100 as previously mentioned. The second input 220 is further configured to provide the phase shifted LO signal including the calibration code value LOIP, LOIN, LOQP, LOON to the plurality of switches M1[0] - M4[0]. The mixer 200 further comprises output(s) 230 configured to output a baseband signal comprising the radio frequency signal RF_i, RF_q multiplied with the phase shifted LO signal including the calibration code value LOIP, LOIN, LOQP, LOQN.

In the digital downconverter architecture in Fig. 3 the mixer switches are split into many cells 250n. First mixer cell includes switches M1[0] - M4[0], second mixer cell includes switches M1[1] - M4[1], etc. On total the mixer 200 has n number of cells. The number n should be chosen high enough to meet SNDR requirements and may also depend on weighing method selected, e.g. binary weighing or equal weighing. The cells can be binary or some other way weighted. Each cell is driven with its own digital LO signal, i.e. LOIP[n:0], LOIN[n:0], etc. In the digital mixer there is only switch transistors that can be arranged closely together to achieve best possible matching. Hence no capacitors or resistances as in conventional mixers are needed in a digital mixer 200.

To provide deep understanding of embodiments of the invention, the different blocks of the DDFS 100 will be described more in detail in the following disclosure.

### Phase accumulator block

The DDFS 100 comprises a phase accumulator block 110 which is driven by FCWs and constant clock (CLK) signals. The phase accumulator block 110 is configured to add a FCW to an output value of a register for each clock sample of the CLK. After reset said value is zero and then increases at the slope given by the FCW. The FCW determines the phase slope and thus the DDFS frequency which is equal to the LO frequency, i.e. "PA_out" (phase accumulator output) in Fig. 4a. PA_out is the value held at the register output plus the FCW for each clock sample.

The phase accumulator block 110 therefore comprises a register block 116, an adder block 112 and a feedback line 114 from the register block 116 output to the adder block 112 as shown in Fig. 3. The register block 116 changes a register input value to a register output value at each rise of the CLK signal, i.e. once per clock period. This value is held at the output until the CLK signal rises again. For example, if the FCW value is 2, starting from reset:

| CLK cycle | FCW | Register output value |
|---|---|---|
| 1 | 2 | FCW + register output (on reset 0) = 2 |
| 2 | 2 | FCW + register output (previous value 2) = 4 |

The PA_out is thereafter outputted to the phase-to-amplitude converter block 120.

### Phase-to-amplitude converter block

The DDFS 100 comprises a phase-to-amplitude converter block 120 which is coupled to the phase accumulator block 110. The phase-to-amplitude converter block 120 converts the phase slope signal received from the phase accumulator block 110 to a LO signal, i.e. the "PAC_out" (phase to amplitude converter output) in Fig. 4b.

In embodiments the converter block 120 is configured to convert the phase slope signal to the LO signal using a square wave function or a sine wave function. This means that the LO signal or PAC_out in Fig. 4b is the square wave signal or sinewave signal waveform output for each CLK hence not a continuous signal but a sampled signal. The PAC_out is outputted to the adder block 130.

In embodiments the converter block 120 is configured to reduce the amplitude of the LO signal from digital full-scale. Hence, the signal from the phase-to-amplitude block 120 is backed off from the full-scale so as to make room for calibration offset value.

### Adder block

The DDFS 100 comprises an adder block 130 which is coupled to phase-to-amplitude converter block 120. The adder block 130 is configured to receive the LO signal (PAC_out) from the phase-to-amplitude converter block 120 and add a calibration code value, i.e. IIP2CAL_I and IIP2CAL_Q, respectively, depending on whether the path is I-path or Q-path, to the LO signal output from the phase-to-amplitude converter block 120. The calibration code value is received by the adder block 130, e.g. from a memory of the DDFS 100.

In embodiments the calibration value is a constant value in the respect that it does not change over time. More specifically, the constant value is predefined and tuned for a mixer 200 of the downconverter 300. This implies that the calibration is performed in factory at production of the DDFS 100. Predefined tables can be provided which indicates different calibration values for different mixer applications. Hence, a suitable calibration value can be pick at production. The calibration value can be stored in a memory (not shown) of the downconverter 300 and fetched from the memory when needed.

In embodiments, the calibration code value is tuned for removing second order nonlinearities of the mixer 200.

In further embodiments, the calibration code value is different for different receivers but constant for one downconverter/receiver. The nonidealities during the manufacturing process causes mismatch in different properties, such as threshold voltage, of the mixer switches. Further, the non-symmetrical layout design by the designer can cause mismatch. However, these effects are not changed over time but stays constant for one physical instance of the mixer. Therefore, the calibration values can be constant and fixed for a single mixer 200. Moreover, the calibrated code effectively creates a mismatch to the LO port to counter the mismatch in the mixer switch itself. Therefore, the output is perfectly in balance and no second order nonlinearity is created.

In further embodiments, the adder block 130 is configured to add a calibration code value to the LO signal so that a maximum value of the LO signal including the calibration code value is less than digital full-scale.

In further embodiments, the adder block 130 is also configured to add a calibration code value to the LO signal so that a minimum value of the LO signal including the calibration code value is greater than zero.

The LO signal including the calibration code must be less than the full-scale in order to maintain the LO waveform. Also, if the LO signal is higher than the maximum value and lower than the minimum value, hence clips at both ends, even the calibration functionality is lost.

### Single-ended-to-differential block

The DDFS 100 comprises a single-ended-to-differential block 140 coupled to the adder block 130. The single-ended-to-differential block 140 is configured to receive the LO signal including the calibration code value from the adder block 130 and add a 180-degree phase shift to the output signal added with the calibration signal. The 180-degree phase shift signal is required to create differential downconverter output signals. The differential outputs are required to suppress the second order nonlinearity. With the LO signal including the optimal calibration code and non-ideal mixer the differential outputs (IP, IN) are in balance and therefore have no differential second order nonlinearity component. Without the differential output there is no way of suppressing the second order nonlinearity.

The output of the differential block 140 are the digital LO signals LOIP[n:0], LOIN[n:0], LOQP[n:0], LOQN[n:0], used for IIP2 calibration of the switches in the digital mixer 200 of the downconverter 300. Hence, the output of the single-ended-to-differential block 140 is 180-degree phase shift of the PAC_out + constant calibration code value signal (shown in Fig. 4c) which is equal to the digital LO signal used for IIP2 calibration of the switches in the digital mixer of the downconverter.

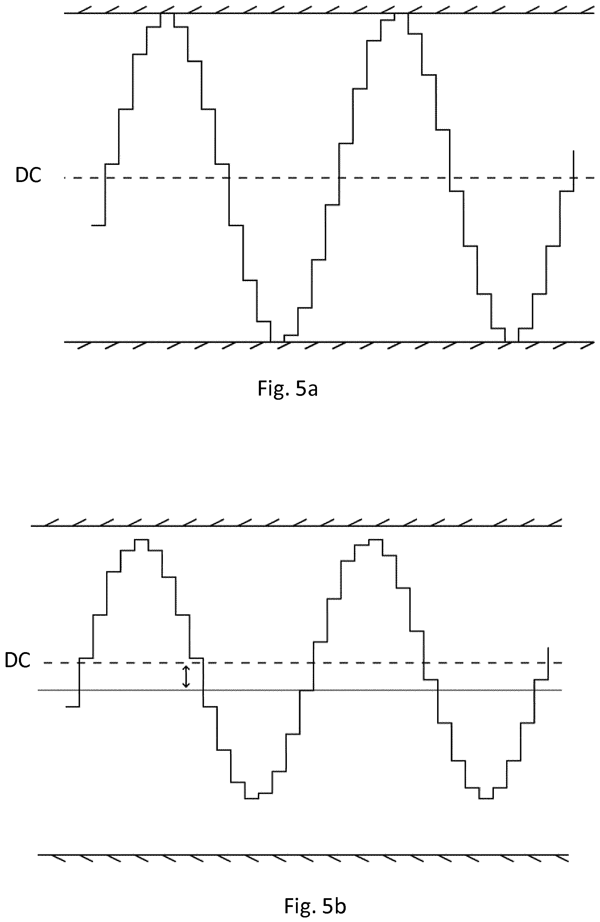

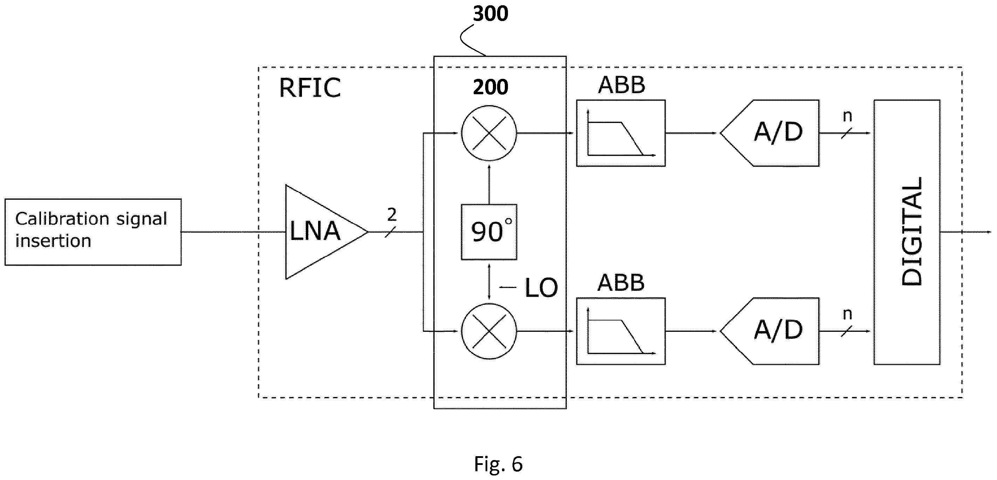

It noted that for simplicity only the processing of the I-path according to the invention is illustrated in Figs. 4a-4c and 5a-5b. However, the processing of the Q-path is the same as for the I-path except for a 90-degree phase shift on the PAC output. Typically, the calibration of the I-path and the Q-path is performed separately. Also, said calibration is usually not performed in parallel but in series. In zero inter frequency (IF) receivers the baseband signal can be downconverted around DC with the I (in-phase) and the Q (quadrature) signals. By using IQ signals the analog baseband (ABB) filter can be simple lowpass filter. The I- and Q-paths are added together in the digital domain (see Fig. 6) to construct the complex signal, i.e. I+jQ.

Further, it is noted that each n signal of the LOIP [n: 0] signals in Fig. 3 is a digital zero "0" or a digital one "1". When the sinewave signal is at maximum all n signals have value "1", and all n signals have values "0" when the sinewave is at minimum. At other time instances some of the n signals have the value "0" and others have the value "1" to effectively create the sinewave curve for mixing of RF signals with LO signals at the mixer 200.

Fig. 5a shows a digital 10-bit full-scale waveform calibration signal LOIP[n:0] without DC offset. The DC level in Fig. 5a is shown with dashed line which is exactly at the center value. It can be seen that there is no room for DC adjustment without clipping the signal. Fig. 5b shows the backed-off from full-scale waveform calibration signal with DC offset added as previously described. The DC level is again shown with dashed line which now is above the center value illustrated with the arrow. In the DDFS 100 there is a single-ended to differential buffer which drives the positive (M1[n:0]) switches with a stronger LO signal. This effect can be used for compensating the mismatch of switches in the mixer 200.

Fig. 6 shows a downconverter according to an embodiment of the invention. A calibration signal is inserted into a low noise amplifier (LNA) of a radio frequency integrated circuit (RFIC). The LNA is typically the first block of the RFIC. The LNA amplifies the signal and adds as little noise as possible. The next block is the downconverter 300 including the LO signal which converts the amplified RF signal to baseband around zero frequency. The ABB filters the unwanted blocker signals including the transmitter (TX) signal and amplifies the signal to a correct level for the analog to digital (A/D) converter (ADC) which converts the filtered signal to the digital domain (DIGITAL) and applies further filtering and combines the I- and Q-paths to a complex IQ signal (I+jQ).

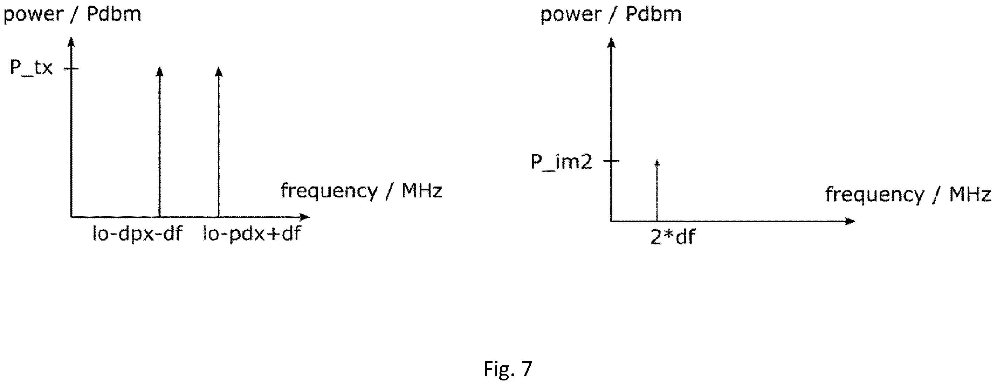

Moreover, it is recognized that IIP2 calibration needs test tones to mixer input that can generated with external generators or with own TX through loopback switch in the Front-end Module (FEM). After the test tones are added, the second order intermodulation product is minimized by optimizing the IIP2CAL calibration values. The calibration is done separately for the I-path and Q-path. The test tone frequencies are at duplex distance of LO frequency and 2xdf apart (1 MHz for example) which is illustrated in the left signal diagram in Fig. 7. Power is the maximum transmit power at the LNA input. The second order intermodulation is at 2*df which is illustrated in the right signal diagram in Fig. 7.

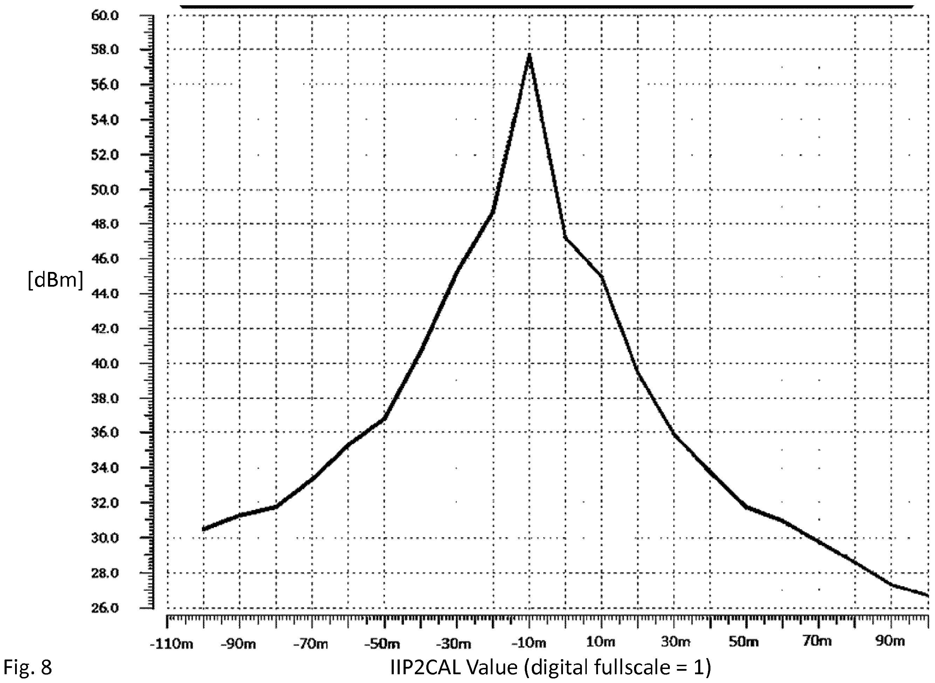

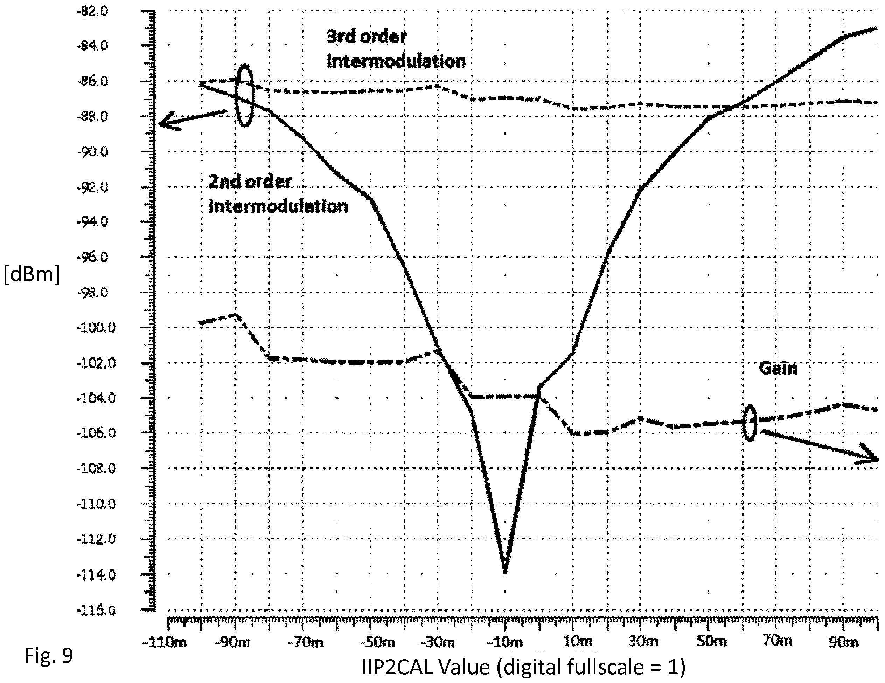

Fig. 8 and 9 shows simulation results of the proposed IIP2 calibration scheme.

Fig. 8 shows the simulation results for IIP2 with different DC offset values added. The x-axis shows different IIP2 calibration values (IIP2CAL), and the y-axis shows the IIP2 value in dBm in Fig. 8. This means that the higher value the better. In Fig. 8 the calibration value, i.e. IIP2CAL constant value, is swept from -100m to 110m. It can be seen from Fig. 8 that by changing the value of the calibration signal IIP2CAL by 10m the IIP2 is improved by 10 dBm.

Fig. 9 shows simulation results for second and third order intermodulation and the gain. In Fig. 9 there is second and third order intermodulation products as well as gain as a function of the LO offset, i.e. the calibration value (IIP2CAL constant). The x-axis shows the LO offset values (IIP2CAL), i.e. calibration values, and the y-axis shows the intermodulation hence the lower value the better. As seen from Fig. 9 the second order intermodulation product is minimized and the third order intermodulation is kept quite constant. Furthermore, it is noted from Fig. 9 that the gain is not affected by IIP2 calibration.

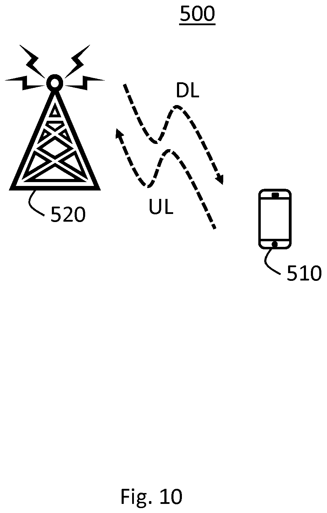

The downconverter 300 and hence also the DDFS 100 and the mixer 200 according to embodiments of the invention can in non-limiting examples be implemented/comprised in a client device 510 and/or a network access node 520 of a wireless communication system 500, such as 3GPP new radio (NR). Fig. 10 illustrates a wireless communication system 500 according to an embodiment of the invention. The wireless communication system 500 comprises a client device 510 and a network access node 520 configured to operate in the wireless communication system 500. For simplicity, the wireless communication system 500 shown in Fig. 10 only comprises one client device 510 and one network access node 520. However, the wireless communication system 500 may comprise any number of client devices 510 and any number of network access nodes 520 without deviating from the scope of the invention. The client device 510 and a network access node 520 can perform uplink and/or downlink communication.

The client device 510, may be denoted as a user device, a User Equipment (UE), a mobile station, an internet of things (IoT) device, a sensor device, a wireless terminal and/or a mobile terminal, is enabled to communicate wirelessly in a wireless communication system, sometimes also referred to as a cellular radio system. The UEs may further be referred to as mobile telephones, cellular telephones, computer tablets or laptops with wireless capability. The UEs in this context may be, for example, portable, pocket-storable, hand-held, computer-comprised, or vehicle-mounted mobile devices, enabled to communicate voice and/or data, via the radio access network, with another entity, such as another receiver or a server. The UE can be a Station (STA), which is any device that contains an IEEE 802.11-conformant Media Access Control (MAC) and Physical Layer (PHY) interface to the Wireless Medium (WM). The UE may also be configured for communication in 3GPP related LTE and LTE-Advanced, in WiMAX and its evolution, and in fifth generation wireless technologies, such as New Radio.

The network access node 520 may also be denoted as a radio network access node, an access network access node, an access point, or a base station, e.g. a Radio Base Station (RBS), which in some networks may be referred to as transmitter, "gNB", "gNodeB", "eNB", "eNodeB", "NodeB" or "B node", depending on the technology and terminology used. The radio network access nodes may be of different classes such as e.g. macro eNodeB, home eNodeB or pico base station, based on transmission power and thereby also cell size. The radio network access node can be a Station (STA), which is any device that contains an IEEE 802.11-conformant Media Access Control (MAC) and Physical Layer (PHY) interface to the Wireless Medium (WM). The radio network access node may also be a base station corresponding to the fifth generation (5G) wireless systems.

Finally, it should be understood that the invention is not limited to the embodiments described above, but also relates to and incorporates all embodiments within the scope of the appended independent claims.

## Claims

1. A digital frequency synthesis circuit (100) for generating a 180°-phase shifted local oscillator, LO, signal for a digital mixer (200) of a downconverter (300), wherein the digital frequency synthesis circuit (100) includes an I-path and a Q-path, and comprises:
• a phase accumulator block (110) configured to:
∘ obtain a register output value,
∘ generate a phase slope signal by adding a frequency control word, FCW, to the register output value;
• a converter block (120) configured to:
o convert the phase slope signal to a LO signal;
• an adder block (130) configured to:
o add a calibration code value (IIP2CAL_I, IIP2CAL_Q) to the LO signal, wherein the calibration code value (IIP2CAL_I, IIP2CAL_Q) is for second order input intercept point, IIP, calibration of the switches of the digital mixer (200); and
• a differential block (140) configured to:
∘ generate the 180°-phase shifted LO signal, the 180°-phase shifted LO signal including the calibration code value (IIP2CAL_I, IIP2CAL_Q), by phase shifting the LO signal including the calibration code value (IIP2CAL_I, IIP2CAL_Q), and
∘ provide the 180°-phase shifted LO signal to the digital mixer (200).

2. The digital frequency synthesis circuit (100) according to claim 1, wherein the converter block (120) is further configured to reduce the amplitude of the LO signal from digital full-scale.

3. The digital frequency synthesis circuit (100) according to claim 1 or 2, wherein the LO signal is a square wave signal or a sine wave signal.

4. The digital frequency synthesis circuit (100) according to any one of the preceding claims, wherein the adder block (130) is further configured to add a calibration code value to the LO signal, so that a maximum value of the LO signal including the calibration code value is less than digital full-scale.

5. The digital frequency synthesis circuit (100) according to any one of the preceding claims, wherein the adder block (130) is further configured to add a calibration code value to the LO signal, so that a minimum value of the LO signal including the calibration code value is greater than zero.

6. The digital frequency synthesis circuit (100) according to any one of the preceding claims, wherein the calibration code value is a constant value.

7. The digital frequency synthesis circuit (100) according to claim 6, wherein the constant value is predefined and tuned for the digital mixer (200) of the downconverter (300).

8. The digital frequency synthesis circuit (100) according to claim 7, wherein the calibration code value is tuned for removing second order nonlinearities of the digital mixer (200).

9. A digital mixer (200) for a downconverter (300), wherein the digital mixer (200) includes an I-path and a Q-path, and comprises:
• a first input (210) configured to:
∘ receive a radio frequency signal (RF_i, RF_q) for downconversion,
∘ provide the radio frequency signal (RF_i, RF_q) to a plurality of switches (M1[0] - M4[0]) of the digital mixer (200);
• a second input (220) configured to:
∘ receive a 180°-phase shifted LO signal including a calibration code value (LOIP, LOIN, LOQP, LOQN) from a digital frequency synthesis circuit (100) according to any one of claims 1 to 8,
∘ provide the 180°-phase shifted LO signal including the calibration code value (LOIP, LOIN, LOQP, LOQN) to the plurality of switches (M1[0] - M4[0]), wherein the calibration code value (IIP2CAL_I, IIP2CAL_Q) is for second order input intercept point, IIP, calibration of the plurality of switches (M1[o] - M4[0]) of the digital mixer (200); and
• an output (230) configured to:
∘ output a baseband signal comprising the radio frequency signal (RF_i, RF_q) multiplied with the 180°-phase shifted LO signal including the calibration code value (LOIP, LOIN, LOQP, LOQN).

10. The digital mixer (200) according to claim 9, further lacking decoupling capacitors and bias resistors.

11. A downconverter (300) for downconverting a radio frequency signal to a baseband signal, the downconverter (300) comprising:
• a digital frequency synthesis circuit (100) according to any one of claims 1 to 8, and
• a digital mixer (200) according to claim 9 or 10.

12. A method (400) for generating a 180°-phase shifted LO signal performed by a digital frequency synthesis circuit (100) according to any of claims 1 - 8, the method comprising the steps of:
∘ obtaining (step 402), by the phase accumulator block (110), the register output value;
∘ generating (step 404), by the phase accumulator block (110), the phase slope signal by adding the frequency control word, FCW, to the register output value;
∘ converting (step 406), by the converter block (120), the phase slope signal to the LO signal;
∘ adding (step 408), by the adder block (130), the second order input intercept point calibration code value (IIP2CAL_I, IIP2CAL_Q) to the LO signal, wherein the calibration code value (IIP2CAL_I, IIP2CAL_Q) is for second order input intercept point, IIP, calibration of the switches of the digital mixer (200);
∘ generating, by the differential block (140), the 180°-phase shifted LO signal, the 180° - phase shifted LO signal including the calibration code value (IIP2CAL_I, IIP2CAL_Q), by phase shifting the LO signal including the calibration code value (IIP2CAL_I, IIP2CAL_Q), and
∘ providing, by the differential block (140), the 180°-phase shifted LO signal to the digital mixer (200).

## Patentansprüche

1. Digitale Frequenzsyntheseschaltung (100) zum Erzeugen eines um 180° phasenverschobenen Lokaloszillator(LO)-Signals für einen digitalen Mischer (200) eines Abwärtswandlers (300), wobei die digitale Frequenzsyntheseschaltung (100) einen I-Pfad und einen Q-Pfad beinhaltet und Folgendes umfasst:
• einen Phasenakkumulatorblock (110), der zu Folgendem konfiguriert ist:
∘ Erlangen eines Registerausgabewerts,
∘ Erzeugen eines Phasensteigungssignals durch Addieren eines Frequenzsteuerworts (frequency control word - FCW) zu dem Registerausgabewert;
• einen Wandlerblock (120), der zu Folgendem konfiguriert ist:
∘ Umwandeln des Phasensteigungssignals in ein LO-Signal;
• einen Addierblock (130), der zu Folgendem konfiguriert ist:
∘ Addieren eines Kalibrierungscodewerts (IIP2CAL_I, IIP2CAL_Q) zu dem LO-Signal, wobei der Kalibrierungscodewert (IIP2CAL_I, IIP2CAL_Q) zur Kalibrierung des Eingangsschnittpunkts (input intercept point - IIP) zweiter Ordnung der Schalter des digitalen Mischers (200) dient; und
• einen Differenzialblock (140), der zu Folgendem konfiguriert ist:
∘ Erzeugen des um 180° phasenverschobenen LO-Signals, wobei das um 180° phasenverschobene LO-Signal den Kalibrierungscodewert (IIP2CAL_I, IIP2CAL_Q) beinhaltet, durch Phasenverschieben des LO-Signals, das den Kalibrierungscodewert (IIP2CAL_I, IIP2CAL_Q) beinhaltet, und
∘ Bereitstellen des um 180° phasenverschobenen LO-Signals an den digitalen Mischer (200).

2. Digitale Frequenzsyntheseschaltung (100) nach Anspruch 1, wobei der Wandlerblock (120) ferner dazu konfiguriert ist, die Amplitude des LO-Signals von dem digitalen Vollausschlag zu reduzieren.

3. Digitale Frequenzsyntheseschaltung (100) nach Anspruch 1 oder 2, wobei das LO-Signal ein Rechteckwellensignal oder ein Sinuswellensignal ist.

4. Digitale Frequenzsyntheseschaltung (100) nach einem der vorhergehenden Ansprüche, wobei der Addierblock (130) ferner dazu konfiguriert ist, einen Kalibrierungscodewert zu dem LO-Signal zu addieren, so dass ein Maximalwert des LO-Signals, das den Kalibrierungscodewert beinhaltet, kleiner als der digitale Vollausschlag ist.

5. Digitale Frequenzsyntheseschaltung (100) nach einem der vorhergehenden Ansprüche, wobei der Addierblock (130) ferner dazu konfiguriert ist, einen Kalibrierungscodewert zu dem LO-Signal zu addieren, so dass ein Minimalwert des LO-Signals, das den Kalibrierungscodewert beinhaltet, größer als Null ist.

6. Digitale Frequenzsyntheseschaltung (100) nach einem der vorhergehenden Ansprüche, wobei der Kalibrierungscodewert ein konstanter Wert ist.

7. Digitale Frequenzsyntheseschaltung (100) nach Anspruch 6, wobei der konstante Wert für den digitalen Mischer (200) des Abwärtswandlers (300) vordefiniert und abgestimmt ist.

8. Digitale Frequenzsyntheseschaltung (100) nach Anspruch 7, wobei der Kalibrierungscodewert zum Entfernen von Nichtlinearitäten zweiter Ordnung des digitalen Mischers (200) abgestimmt ist.

9. Digitaler Mischer (200) für einen Abwärtswandler (300), wobei der digitale Mischer (200) einen I-Pfad und einen Q-Pfad beinhaltet und Folgendes umfasst:
• einen ersten Eingang (210), der zu Folgendem konfiguriert ist:
∘ Empfangen eines Hochfrequenzsignals (RF_i, RF_q) zur Abwärtswandlung,
∘ Bereitstellen des Hochfrequenzsignals (RF_i, RF_q) an eine Vielzahl von Schaltern (M1[0]-M4[0]) des digitalen Mischers (200);
• einen zweiten Eingang (220), der zu Folgendem konfiguriert ist:
∘ Empfangen eines um 180° phasenverschobenen LO-Signals, das einen Kalibrierungscodewert (LOIP, LOIN, LOQP, LOQN) beinhaltet, von einer digitalen Frequenzsyntheseschaltung (100) nach einem der Ansprüche 1 bis 8,
∘ Bereitstellen des um 180° phasenverschobenen LO-Signals, das den Kalibrierungscodewert (LOIP, LOIN, LOQP, LOQN) beinhaltet, an die Vielzahl von Schaltern (M1[0]-M4[0]), wobei der Kalibrierungscodewert (IIP2CAL_I, IIP2CAL_Q) zur Kalibrierung des Eingangsschnittpunkts (IIP) zweiter Ordnung der Vielzahl von Schaltern (M1[0]-M4[0]) des digitalen Mischers (200) dient; und
• einen Ausgang (230), der zu Folgendem konfiguriert ist:
∘ Ausgeben eines Basisbandsignals, umfassend das Hochfrequenzsignal (RF_i, RF_q) multipliziert mit dem um 180° phasenverschobenen LO-Signal, das den Kalibrierungscodewert (LOIP, LOIN, LOQP, LOQN) beinhaltet.

10. Digitaler Mischer (200) nach Anspruch 9, dem ferner Entkopplungskondensatoren und Vorspannungswiderstände fehlen.

11. Abwärtswandler (300) zum Abwärtswandeln eines Hochfrequenzsignals in ein Basisbandsignal, wobei der Abwärtswandler (300) Folgendes umfasst:
• eine digitale Frequenzsyntheseschaltung (100) nach einem der Ansprüche 1 bis 8, und
• einen digitalen Mischer (200) nach Anspruch 9 oder 10.

12. Verfahren (400) zum Erzeugen eines um 180° phasenverschobenen LO-Signals, das von einer digitalen Frequenzsyntheseschaltung (100) nach einem der Ansprüche 1-8 durchgeführt wird, wobei das Verfahren die folgenden Schritte umfasst:
∘ Erlangen (Schritt 402) des Registerausgabewerts durch den Phasenakkumulatorblock (110);
∘ Erzeugen (Schritt 404) des Phasensteigungssignals durch den Phasenakkumulatorblock (110) durch Addieren des Frequenzsteuerworts (FCW) zum Registerausgabewert;
∘ Umwandeln (Schritt 406) des Phasensteigungssignals in das LO-Signal durch den Wandlerblock (120);
∘ Addieren (Schritt 408) des Kalibrierungscodewerts (IIP2CAL_I, IIP2CAL_Q) für den Eingangsschnittpunkt zweiter Ordnung zu dem LO-Signal durch den Addierblock (130), wobei der Kalibrierungscodewert (IIP2CAL_I, IIP2CAL_Q) zur Kalibrierung des Eingangsschnittpunkts (IIP) zweiter Ordnung der Schalter des digitalen Mischers (200) dient;
∘ Erzeugen des um 180° phasenverschobenen LO-Signals durch den Differenzialblock (140), wobei das um 180° phasenverschobene LO-Signal den Kalibrierungscodewert (IIP2CAL_I, IIP2CAL_Q) beinhaltet, durch Phasenverschieben des LO-Signals, das den Kalibrierungscodewert (IIP2CAL_I, IIP2CAL_Q) beinhaltet, und
∘ Bereitstellen des um 180° phasenverschobenen LO-Signals für den digitalen Mischer (200) durch den Differenzialblock (140).

## Revendications

1. Circuit de synthèse de fréquence numérique (100) pour générer un signal d'oscillateur local, LO, déphasé de 180° pour un mélangeur numérique (200) d'un convertisseur-abaisseur (300), dans lequel le circuit de synthèse de fréquence numérique (100) comporte un chemin I et un chemin Q, et comprend :
• un bloc accumulateur de phase (110) configuré pour :
∘ obtenir une valeur de sortie de registre,
∘ générer un signal de pente de phase en ajoutant un mot de commande de fréquence, FCW, à la valeur de sortie de registre ;
• un bloc convertisseur (120) configuré pour :
∘ convertir le signal de pente de phase en un signal LO ;
• un bloc additionneur (130) configuré pour :
∘ ajouter une valeur de code d'étalonnage (IIP2CAL_I, IIP2CAL_Q) au signal LO, dans lequel la valeur de code d'étalonnage (IIP2CAL_I, IIP2CAL_Q) est destinée à l'étalonnage de point d'interception d'entrée de second ordre, IIP, des commutateurs du mélangeur numérique (200) ; et
• un bloc différentiel (140) configuré pour :
∘ générer le signal LO déphasé de 180°, le signal LO déphasé de 180° comportant la valeur de code d'étalonnage (IIP2CAL_I, IIP2CAL_Q), en déphaseant le signal LO comportant la valeur de code d'étalonnage (IIP2CAL_I, IIP2CAL_Q), et
∘ fournir le signal LO déphasé de 180° au mélangeur numérique (200).

2. Circuit de synthèse de fréquence numérique (100) selon la revendication 1, dans lequel le bloc convertisseur (120) est également configuré pour réduire l'amplitude du signal LO par rapport à la pleine échelle numérique.

3. Circuit de synthèse de fréquence numérique (100) selon la revendication 1 ou 2, dans lequel le signal LO est un signal d'onde carrée ou un signal d'onde sinusoïdale.

4. Circuit de synthèse de fréquence numérique (100) selon l'une quelconque des revendications précédentes, dans lequel le bloc additionneur (130) est également configuré pour ajouter une valeur de code d'étalonnage au signal LO, de sorte qu'une valeur maximale du signal LO comportant la valeur de code d'étalonnage est inférieure à la pleine échelle numérique.

5. Circuit de synthèse de fréquence numérique (100) selon l'une quelconque des revendications précédentes, dans lequel le bloc additionneur (130) est également configuré pour ajouter une valeur de code d'étalonnage au signal LO, de sorte qu'une valeur minimale du signal LO comportant la valeur de code d'étalonnage est supérieure à zéro.

6. Circuit de synthèse de fréquence numérique (100) selon l'une quelconque des revendications précédentes, dans lequel la valeur de code d'étalonnage est une valeur constante.

7. Circuit de synthèse de fréquence numérique (100) selon la revendication 6, dans lequel la valeur constante est prédéfinie et accordée pour le mélangeur numérique (200) du convertisseur-abaisseur (300).

8. Circuit de synthèse de fréquence numérique (100) selon la revendication 7, dans lequel la valeur de code d'étalonnage est réglée pour supprimer les non-linéarités de second ordre du mélangeur numérique (200).

9. Mélangeur numérique (200) pour un convertisseur-abaisseur (300), dans lequel le mélangeur numérique (200) comporte un chemin I et un chemin Q, et comprend :
• une première entrée (210) configurée pour :
∘ recevoir un signal radiofréquence (RF_i, RF_q) pour une conversion vers le bas,
∘ fournir le signal radiofréquence (RF_i, RF_q) à une pluralité de commutateurs (M1[0] - M4[0]) du mélangeur numérique (200) ;
• une seconde entrée (220) configurée pour :
∘ recevoir un signal LO déphasé de 180° comportant une valeur de code d'étalonnage (LOIP, LOIN, LOQP, LOQN) provenant d'un circuit de synthèse de fréquence numérique (100) selon l'une quelconque des revendications 1 à 8,
∘ fournir le signal LO déphasé de 180° comportant la valeur de code d'étalonnage (LOIP, LOIN, LOQP, LOQN) à la pluralité de commutateurs (M1[0] - M4[0]), dans lequel la valeur de code d'étalonnage (IIP2CAL_I, IIP2CAL_Q) est pour l'étalonnage de point d'interception d'entrée de second ordre, IIP, de la pluralité de commutateurs (M1[0] - M4[0]) du mélangeur numérique (200) ; et
• une sortie (230) configurée pour :
∘ délivrer un signal en bande de base comprenant le signal radiofréquence (RF_i, RF_q) multiplié par le signal LO déphasé de 180° comportant la valeur de code d'étalonnage (LOIP, LOIN, LOQP, LOQN).

10. Mélangeur numérique (200) selon la revendication 9, dépourvu également de condensateurs de découplage et de résistances de polarisation.

11. Convertisseur-abaisseur (300) pour convertir un signal radiofréquence en un signal en bande de base, le convertisseur-abaisseur (300) comprenant :
• un circuit de synthèse de fréquence numérique (100) selon l'une quelconque des revendications 1 à 8, et
• un mélangeur numérique (200) selon la revendication 9 ou 10.

12. Procédé (400) pour générer un signal LO déphasé de 180° réalisé par un circuit de synthèse de fréquence numérique (100) selon l'une quelconque des revendications 1 à 8, le procédé comprenant les étapes suivantes :
∘ l'obtention (étape 402), par le bloc accumulateur de phase (110), de la valeur de sortie de registre ;
∘ la génération (étape 404), par le bloc accumulateur de phase (110), du signal de pente de phase en ajoutant le mot de commande de fréquence, FCW, à la valeur de sortie de registre ;
∘ la conversion (étape 406), par le bloc convertisseur (120), du signal de pente de phase en signal LO ;
∘ l'ajout (étape 408), par le bloc additionneur (130), de la valeur de code d'étalonnage de point d'interception d'entrée de second ordre (IIP2CAL_I, IIP2CAL_Q) au signal LO, dans lequel la valeur de code d'étalonnage (IIP2CAL_I, IIP2CAL_Q) est destinée à l'étalonnage de point d'interception d'entrée de second ordre, IIP, des commutateurs du mélangeur numérique (200) ;
∘ la génération, par le bloc différentiel (140), du signal LO déphasé de 180°, le signal LO déphasé de 180° comportant la valeur de code d'étalonnage (IIP2CAL_I, IIP2CAL_Q), en déphaseant le signal LO comportant la valeur de code d'étalonnage (IIP2CAL_I, IIP2CAL_Q), et
∘ la fourniture, par le bloc différentiel (140), du signal LO déphasé de 180° au mélangeur numérique (200).
